Europäisches Patentamt

(19) European Patent Office

Office européen des brevets

(11) Publication number: **0 083 667**
**B1**

(12) **EUROPEAN PATENT SPECIFICATION**

(45) Date of publication of patent specification: **25.11.87**

(51) Int. Cl.⁴: **H 01 G 7/04, H 01 L 37/02**

(21) Application number: **82902210.2**

(22) Date of filing: **27.07.82**

(86) International application number:
**PCT/JP82/00290**

(87) International publication number:
**WO 83/00404 03.02.83 Gazette 83/04**

(54) **METHOD OF MANUFACTURING A PYROELECTRIC UNIT.**

(30) Priority: **27.07.81 JP 117551/81**
**29.07.81 JP 117806/81**
**29.07.81 JP 117807/81**

(43) Date of publication of application:
**20.07.83 Bulletin 83/29**

(45) Publication of the grant of the patent:
**25.11.87 Bulletin 87/48**

(84) Designated Contracting States:
**FR**

(56) References cited:
**JP-B-35 007 619**
**JP-B-51 048 277**
**US-A-3 939 098**

**APPLIED PHYSICS LETTERS, vol. 36, no. 10,
15th May 1980, pages 817-818, American
Institute of Physics, New York, US; G.J.
GARDOPEE et al.: "Pyroelectric glass-ceramics"**

(73) Proprietor: **SONY CORPORATION**
**7-35 Kitashinagawa 6-Chome Shinagawa-ku
Tokyo 141 (JP)**

(72) Inventor: **MORI, Toshio Sony Corporation
7-35 Kitashinagawa 6-chome Shinagawa-ku
Tokyo 141 (JP)**

(74) Representative: **Thomas, Christopher Hugo
et al
D Young & Co 10 Staple Inn
London WC1V 7RD (GB)**

## Description

This invention relates to methods of preparing pyroelectric materials.

In general, a piezoelectric material may be classified as a pyroelectric material or a non-pyroelectric material, depending on the presence or absence of spontaneous polarization. The pyroelectric material may further be classified as a ferroelectric material or a non-ferroelectric material, depending on whether the direction or sense of the spontaneous polarization $P_s$ can be switched by application of an electric field or not. Hence, a pyroelectric material can always be used as a piezoelectric material, and some pyroelectric materials can be used as ferroelectric material. Pyroelectric material shows a pyroelectric effect, that is, the property that electric charges are produced on the surface upon heating the material. This property enables the material to be used in the field of infra-red sensors and heat sensitive elements.

Pyroelectric materials usually exist as single crystals or polycrystals or as a complex with other materials. In general, single crystals, particularly larger crystals, can only be manufactured with difficulty, whereas the manufacture of polycrystalline and complex materials has advantages over the single crystals in equipment and material costs, manufacturing time and capability of manufacturing large or desired size material. It is to be noted that the polycrystalline pyroelectric material is formed only of pyroelectric crystalline material and hence exhibits more intense pyroelectric effect than the complex pyroelectric material.

In known methods of manufacture of such polycrystalline or complex pyroelectric material, crystalline particles or powders of ferroelectric material in which the sense of spontaneous polarization can be switched easily, such as $BaTiO_3$ particles, are baked to form a solid layer, to which an electric field is applied for orienting the spontaneous polarization $P_s$ substantially in the same direction (poling process). However, only ferroelectric material showing spontaneous polarization that can be switched easily in sense or direction can be used as the starting material. Neither ferroelectric material showing spontaneous polarization that cannot be switched easily in sense or direction nor non-ferroelectric material can be used for the preparation of a polycrystalline or complex pyroelectric material. In addition, the sense of the spontaneous polarization cannot be aligned perfectly when the poling operation is performed on the baked material, and the pyroelectric properties then obtained are usually inferior to those possessed by the single crystal pyroelectric material.

Japanese patent specification JP—B1—35-7619 discloses manufacture of a ferroelectric amplifier element by comminuting barium titanate porcelain in a ball mill to a particle size less than 1 μm, and suspending the resulting particles in a dispersion medium such as methanol or ethanol. The dispersion is placed between a platinum plate forming a cathode, and a further metal plate forming an anode. On applying a voltage, a thin film of ferroelectric material is produced by electrophoresis on the platinum plate.

According to the present invention there is provided a method of preparing a pyroelectric material, the method comprising;

dispersing crystalline pyroelectric particles in a liquid;

introducing the resulting dispersion between an opposing pair of electrodes; and

establishing an electric field between said electrodes with a sufficient magnitude to cause said particles to be deposited in a layer on one of said electrodes;

characterised by:

changing the temperature of said particles before deposition of said particles on said one electrode, the temperature change being sufficient to orient the pyroelectric axes of the crystalline particles in the deposited layer.

Said electrodes may be immersed in said liquid, or alternatively said liquid may be sprayed into the space between said electrodes.

Hence it is possible to obtain polycrystalline or complex pyroelectric material in the form of a layer of polarized pyroelectric crystalline particles by using pyroelectric crystalline particles in which it is difficult or impossible to switch the direction or sense of the spontaneous polarization $P_s$. By using pyroelectric crystalline particles in which it is difficult or impossible to switch the direction or sense of the spontaneous polarization $P_s$, inexpensive pyroelectric material or higher quality can be manufactured from a wide range of starting material, and also pyroelectric material of a superior quality can be obtained, because the pyroelectric axes of the individual particles can be aligned with higher accuracy.

The invention will now be described by way of example with reference to the accompanying drawings, throughout which like parts are referred to by like references, and in which:

Figures 1A and B are schematic views for explaining the pyroelectric effect;

Figure 2 is a schematic sectional view for explaining a method of depositing particles by electrophoresis;

Figure 3 is a sectional view showing apparatus for use in a method according to the present invention;

Figure 4 is a schematic sectional view showing a device for testing a pyroelectric material;

Figure 5 is a time chart showing current signals obtained from the device of Figure 4; and

Figures 6 to 8 are sectional views showing second to fourth apparatuses for use in respective methods according to the present invention.

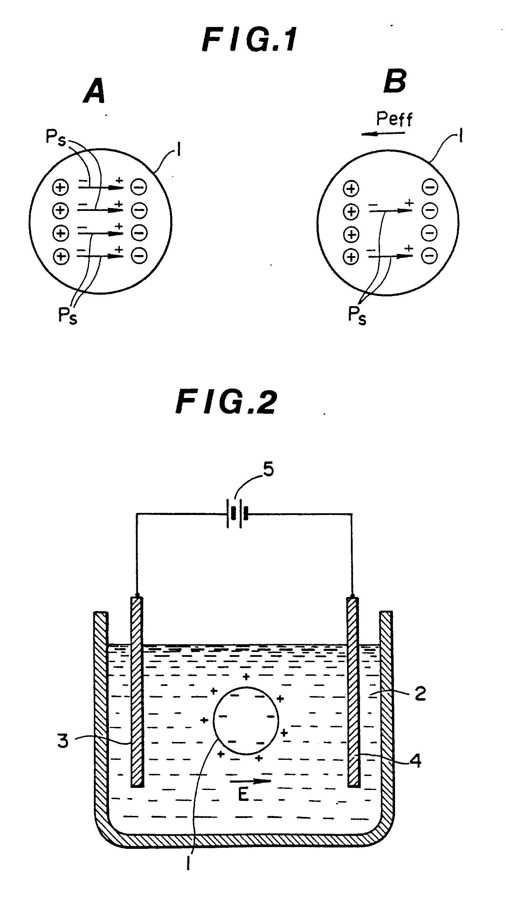

The general properties of pyroelectric crystal particles will first be explained with reference to Figures 1A and 1B. The inner state of a pyroelectric crystalline particle 1 in the quiescent state is shown schematically in Figure 1A, wherein the arrow marks represent spontaneous electric

polarization $P_s$, and the plus and minus marks in circles represent inner charges or electric dipoles. It is assumed that one arrow mark $P_s$ is electrically equivalent to a pair of the inner charges (plus and minus marks in circles). In the quiescent state shown in Figure 1A, spontaneous polarization $P_s$ is cancelled or balanced by the equal amount of the inner charge pairs, so that the apparent charge or apparent electric dipole of the pyroelectric crystal particle is zero. When the crystalline particle 1. in the quiescent state, is subjected to a temperature change such that spontaneous polarization $P_s$ has decreased as shown in Figure 1B, the amount of inner charge pairs surpasses that of spontaneous polarization $P_s$, effectively resulting in inner charge pairs equal in number to the difference between the number of the inner charge pairs and that of the spontaneous polarization $P_s$. Thus, electric dipoles as shown by the arrow mark $P_{eff}$ in Figure 1B appear in the crystalline particle 1. Following such a temperature change, charge pairs equal to the above difference combine and disappear as a function of so-called dielectric relaxation time, until the quiescent state or balanced state in which the inner charge pairs are equal to the spontaneous polarization $P_s$ is again reached. It is to be understood that the sense of change in the amount of polarization $P_s$ (increase or decrease) depends on the sense of change in temperature (rise or fall of temperature) and, when the amount of polarization $P_s$ has increased and exceeded that of the inner charge pairs, the apparent electric dipole $P_{eff}$ has the same sense as $P_s$, and the phenomenon of relaxation takes place in the sense to produce new inner charge pairs.

The method of electric deposition by electrophoresis, sometimes called simply electric deposition, will now be described.

In general, when dispersed in a liquid, solid particles assume plus or minus charges. For example, in Figure 2, the solid particles 1 (dispersed particles) in a liquid (dispersion medium) assume negative charges. When a pair of electrodes 3 and 4 are mounted in the dispersion medium 2 in opposition to and at a certain distance from each other, and a dc voltage is applied across the electrodes 3 and 4 from a dc source 5, the particles are displaced by an electric field E towards the positive electrode 3 (electrophoresis) to be deposited in layers on the surface of the electrode 3 serving as a substrate. This phenomenon is utilized in electrophoretic painting and in other fields. Electrophoresis takes place in the direction of the negative electrode when the dispersed particles assume positive charges.

In a method according to the present invention for manufacturing a pyroelectric structure making use of electrophoresis, pyroelectric crystalline particles including ferroelectric or non-ferroelectric crystal grains such as $LiNbO_3$, $LiTaO_3$, $BaTiO_3$ or zirconium-lead titanate materials (PZT and the like) are used as dispersed particles, and a liquid having a high resistivity (R greater than $10^6$ ohm-

cm) such as trichloroethylene is preferably used as the liquid dispersion medium.

Furthermore, each crystalline particles should preferably undergo uniform rise or fall of temperature until each particle migrates towards and is secured to the surface of the electrode or substrate as a result of electrophoresis caused by the above electric field. To this end, a temperature gradient may be created in the liquid dispersion medium along the direction of electrophoresis, or the liquid may be heated or cooled in part or as a whole. Alternatively, the crystalline particles migrating towards the electrode surface may be heated directly by radiation of light or microwaves of a certain wavelength that can be easily absorbed by the crystalline particles. In such a case it is preferred that the particles should be tinted differently according to the absorption wavelength or subjected to similar surface processing. In this manner, the particles migrating towards the electrode surface under the electric field undergo uniform changes in temperature so that electric dipoles corresponding to the pyroelectric polarity are produced due to the aforementioned pyroelectric effects. Thus the particles migrate towards the electrode surface while being polarized by the electric field, that is with pyroelectric axes oriented in the same direction and with the same polarity, and are so affixed to and deposited on the electrode surface. The deposited layer is taken out of the liquid and dried to provide a layer of polarized pyroelectric crystalline particles, or a polycrystalline pyroelectric material.

In an alternative method according to the present invention, that is, a spray method, the pyroelectric crystalline particles are dispersed in an organic liquid preferably of good electrical insulation and high resistivity (R greater than $10^{10}$ ohm-cm, as an example) to form a colloidal liquid which is then sprayed on the surface of an electrode or a substrate to which a vertical electrical field is applied. In this manner, polarized crystalline particles, that is, crystalline particles with pyroelectric axes oriented in the same direction and with the same polarity, are formed in a layer on the substrate surface. A polycrystalline pyroelectric material may be obtained by drying this crystal particle layer to vaporize or decompose organic components.

The polycrystalline pyroelectric material obtained by these methods can be baked if necessary to form a layer of baked material. A complex pyroelectric material can also be produced by mixing or dispersing glass or like material into the dispersion medium as a binder, or by impregnating other materials into the layer of polycrystalline particles taken out of the liquid, or into the dried or baked pyroelectric material.

Hence it is possible to use the pyroelectric material in which the sense of spontaneous polarization cannot be switched or can be switched only with considerable difficulty. Moreover, when using a ferroelectric material in which it is possible to switch the sense of spontaneous polarization, pyroelectric axes of the individual particles can be made to be substantially coincident, so that the polycrystalline or complex pyroelectric materials of superior quality can be obtained easily.

Preferred methods according to the present invention will now be described.

The first method uses pyroelectric crystalline material $LiNbO_3$, which is a ferroelectric crystal in which the switching of the spontaneous polarization $P_s$ is substantially impossible at ambient temperature.

Single crystals of $LiNbO_3$ are comminuted in a mortar and precipitated in ethanol for separation to $LiNbO_3$ powder consisting only of particles less than 1 µm diameter. This powder is dispersed in a liquid dispersion medium. Since trichloroethylene is employed as the liquid dispersion medium, the $LiNbO_3$ powder must be rendered oleophilic by surface treatment. To this end, the powder is mixed into toluene with a silane coupling agent (such as SZ-6070 manufactured by Toray Silicone Co. Ltd.) and thoroughly agitated by application of ultrasonic waves. The powder is recovered using a centrifugal separator, washed thoroughly with toluene and dried with a hot air drier. The $LiNbO_3$ powders thus surface treated are thoroughly dispersed in the trichloroethylene dispersion medium by application of ultrasonic waves. The $LiNbO_3$ particles in trichloroethylene exhibit negative charges.

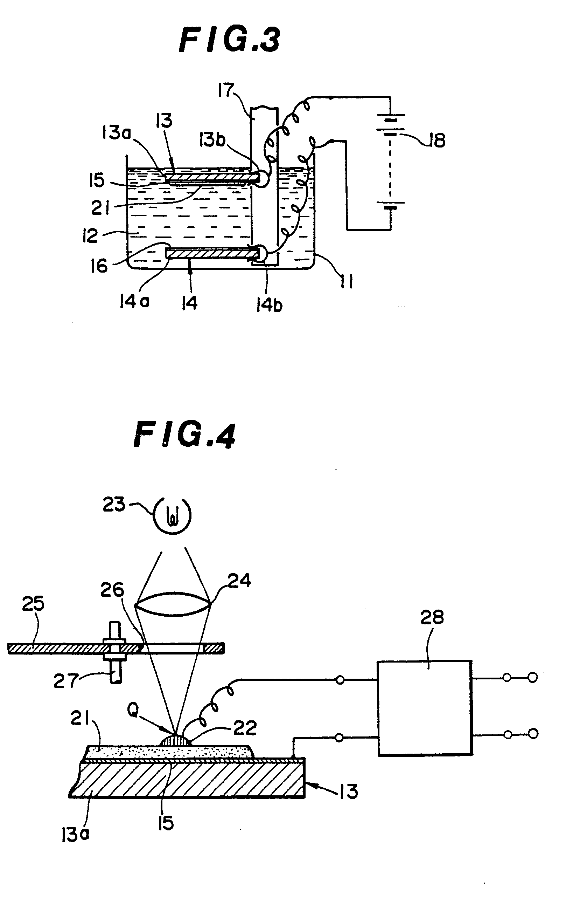

A vessel 11 shown in Figure 3 is filled with a liquid dispersion 12 in which the $LiNbO_3$ powders are dispersed in trichloroethylene. Two electrode plates 13 and 14 are placed horizontally in the liquid dispersion so as to face each other vertically (in the up and down direction in the drawing). The electrode plates 13 and 14 are formed by glass plates 13a and 14a, the surface (especially the opposing surfaces) of which are coated with electrically conductive nesa films ($SnO_2$ films) serving as electrodes. The electrode plates 13 and 14 are supported horizontally by an electrode support post 17 made, for example, of Teflon (Registered Trade Mark) and connected electrically to a dc source 18 by conductive metal fittings 13b and 14b and lead wires. The upper electrode plate 13 in the drawing is positioned near the surface of the liquid dispersion 12, so that the electrode plate 13 and the near-by region is cooled by the heat produced by vaporization at the liquid surface. An electrical voltage of about 5 kV is applied across the electrodes, with the electrode plate 13 being used as positive pole (or anode). In this manner, the $LiNbO_3$ particles are deposited in a layer or layers on the nesa film 15 of the positive electrode plate 13 and are cooled near the electrode plate 13 by evaporation of trichloroethylene at the liquid surface, thus resulting in formation of apparent electric dipoles and orientation of the pyroelectric axes with a predetermined direction and polarity (polarization).

The layer 21 of the $LiNbO_3$ particles thus deposited under polarization on the opposing surfaces of the electrode plate 13 is taken out of the liquid gently together with the electrode plate 13 and dried to provide a polarized polycrystalline pyroelectric material, which can be baked if necessary to a baked pyroelectric product.

Figure 4 shows an example of a testing device for testing pyroelectric effects of the thus obtained polycrystalline pyroelectric material 21. In this figure, the light from a light source 23 such as an incandescent lamp or an infrared lamp is focussed by a lens 24 and collected at a point Q on the surface of the pyroelectric material 21 for raising the temperature at the point Q. A rotary disc 25 having an opening 26 is placed as a light shutter between the lens 24 and the pyroelectric material 21 and rotated about an axis 27 to turn the light irradiation of the point Q on or off to cause a change or gradient in temperature. An electrode 22 about 2 mm diameter is mounted as by deposition of silver paste at the point Q on the polycrystalline pyroelectric body 21 and is electrically connected by a lead to one terminal of a high sensitivity ammeter. A lead wire is led out, for example, from the nesa film 15 on the back of the body 21 and is electrically connected to the other terminal of the high sensitivity ammeter 28.

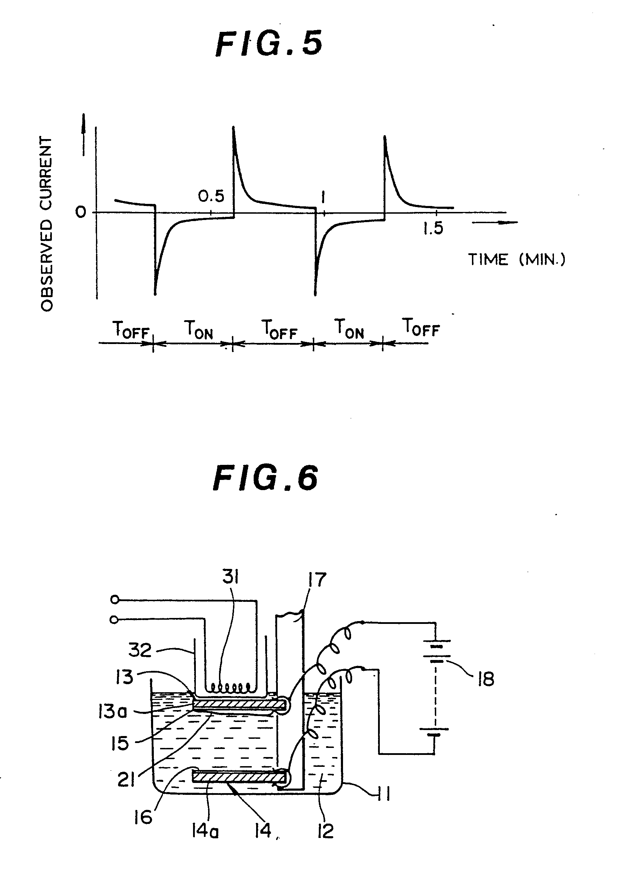

The current as measured with the ammeter 28 when the rotary disc 25 in the testing device is driven in rotation is shown in Figure 5. The time interval $T_{ON}$ that the light from the source 23 reaches the point Q through the opening 26 corresponds to the temperature increase, while the time interval $T_{OFF}$ that the light is interrupted by the disc 25 corresponds to the temperature decrease, thus indicating the presence of pyroelectric effects.

When the polycrystalline pyroelectric body is obtained by electrophoretic deposition under a substantially uniform temperature change or gradient, the resulting pyroelectric effects are uniform throughout the overall area as already described with reference to Figure 3. However, when the temperature change is not uniform as in the case shown in Figure 2, only local orientation is obtained, with occasional fluctuations in pyroelectric effects, and this the resulting pyroelectric material was not usable. This is probably because local temperature increase has been caused due to application of ultrasonic waves aimed at dispersing the pyroelectric crystal particles into the liquid medium.

Reference is made to Figure 6 for a second method according to the present invention.

In this figure, a vessel 11 is filled with a liquid dispersion 12 in which powder-like $LiNbO_3$ particles are dispersed in trichloroethylene and two electrode plates 13 and 14 are placed in a vertically facing relation, as in Figure 3. However, in the apparatus of Figure 6, a heater 31 such as a heater coil is mounted near the upper electrode plate 13 for heating only the region near the electrode plate 13. It is to be noted that the heater 31 is accommodated in a quartz vessel 32 or a vessel made of insulating material, and is placed near the surface of the liquid dispersion 12 for preventing direct contact between the heater 31 and the liquid dispersion 12.

When the heating takes place in the upper zone of the liquid dispersion 12, so-called liquid convection is not caused, and the temperature distribution is substantially uniform so that the liquid temperature has a rising gradient from the lower zone towards the upper zone in the liquid. Thus the powder-like $LiNbO_3$ particles are raised in temperature while they migrate by electrophoresis towards the upper electrode plate 13 under the electrical field applied across the opposing electrodes, and are deposited in a layer on the surface of the nesa film 15 while being polarized by the apparent electric dipoles caused by pyroelectric effects. The sense of polarization is the reverse to that of Figure 3 wherein the particles are lowered in temperature while migrating towards the upper electrode.

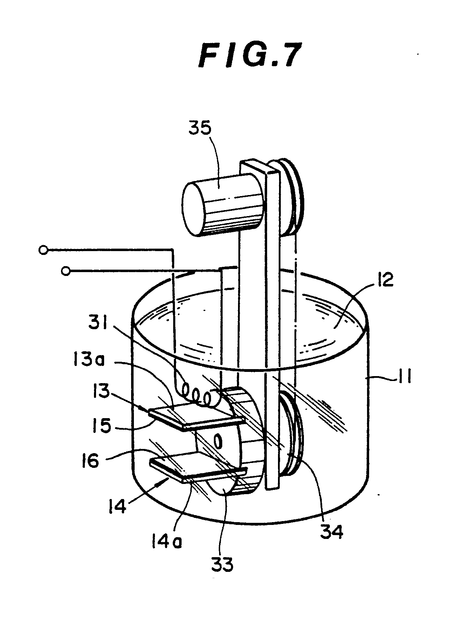

An electrode structure such as shown in Figure 7 is preferably employed for preventing disturbance or loss of the layer of pyroelectric particles likely to occur while the electrode is being taken out of the liquid dispersion.

An arrangement for use in a third method and effective to prevent disturbance of the layer during taking out of the electrode is shown in Figure 7, wherein a pair of electrode plates 13 and 14 are supported by a disc-like rotary table 33 made, for example, of Teflon (Registered Trade Mark) and a pulley 34 mounted on a shaft of the rotary table 33 is rotated by an electric motor 35. The remaining portions are the same as those shown in Figures 3 and 6 with the same reference numerals.

In the apparatus of Figure 7, the electrode plates 13 and 14 are immersed in the liquid dispersion 12, with the positive plate 13 (the side on which the pyroelectric material is formed by electrical deposition) disposed at a higher position (that is, with the nesa film 15 facing downwardly). An electrical voltage of approximately 5 kV is applied across the electrodes, while only the region near the electrode plate 13 is heated by the heater 31. After lapse of à predetermined time interval, for example ten minutes, almost all the $LiNbO_3$ particles are affixed in a layer on the nesa film 15 on the electrode plate 13. At this time, the table 33 is rotated slowly, with the dc voltage still being applied, and the two electrode plates 13 and 14 still immersed in the dispersion 12, until the electrode plate 13 is moved to a lower position and the opposing surface (nesa film) of the electrode faces upwards. The rotation of the table 33 is now stopped. The dc voltage is also turned off, and the electrode plates 13 and 14 are raised slowly together with the table 33. In this manner, the layer of the deposited particles on the electrode plate 13 may be taken out of the liquid without loss. Alternatively, the dc voltage may still be applied during such raising of the electrode plates 13 and 14. At this time, since it is the electrode plate 14 that emerges first from the liquid, it may be presumed that no substantial electrical field applied to the layer after such emergence, and hence no electrostatic force is applied to the layer when the electrode plate 13 carrying the layer emerges from the liquid.

The fourth method to be described below is an aforementioned spray method.

In this fourth method according to the present invention, $LiNbO_3$ crystals are used as pyroelectric crystals. These particles are subjected to comminution, separation by precipitation, and oleophilizing surface treatment with silane coupling agent to form powder-like $LiNbO_3$ particles in the same manner as in the preceding three methods. The particles are thoroughly dispersed in trichloroethylene by application of ultrasonic waves to a colloidal solution. About 0.1 wt percent of solid paraffin may be added in advance to the trichloroethylene.

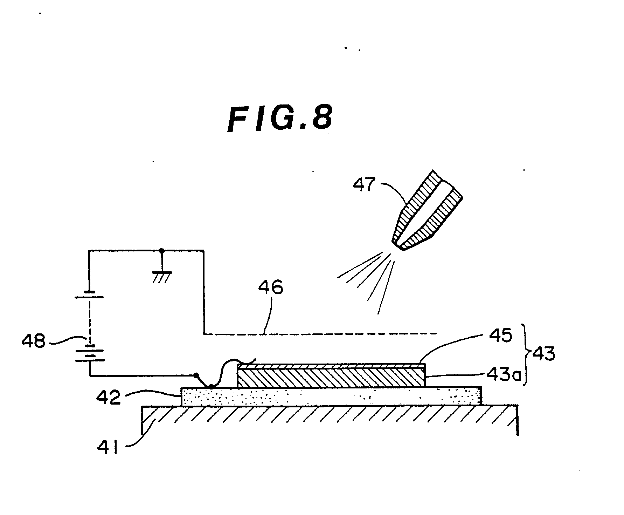

Next, as shown in Figure 8, a quartz plate 42 or like electrically insulating plate is placed on a heating plate 41, and a substrate 43 which serves also as an electrode is placed on the quartz plate 42. The substrate 43 is formed by a glass plate 43a on one surface of which is coated an electrically conductive transparent nesa film ($SnO_2$ film) 45 serving as one electrode. About 5 mm above the nesa film 45, there is placed a counter electrode 46 in the form of a wire screen, and a dc source 48 is connected across the electrodes 45 and 16. A dc voltage of about 2 kV is impressed across the electrodes 45 and 46 for generating an electric field, and the colloidal solution is sprayed by a spray nozzle into a space where the electrical field is generated. In Figure 8, the spray port of the nozzle 47 is shown positioned outside the electrode 46, however, it may be positioned between the electrodes 45 and 46.

When the colloidal solution is ejected through the spray nozzle 47, the $LiNbO_3$ particles dispersed therein are cooled by the heat of vaporization of the sprayed trichloroethylene. When the solution has reached the nesa film 45 of the substrate 43, trichloroethylene is vaporized by being heated by the heating plate 41, so that latent heat of vaporization is absorbed from the particles, thus cooling these particles in a similar manner. Thus the heating plate 41 is heated to about 200°C for vaporizing the trichloroethylene with resultant cooling of the $LiNbO_3$ particles. During such cooling, electric dipoles appear in each $LiNbO_3$ particle due to the pyroelectric effect so that the particles are deposited in a layer on the nesa film 45 of the substrate 43 while the pyroelectric axes thereof are oriented with the same direction and polarity. When the layer has reached a thickness of, for example, about 0.2 mm, the spraying operation may be terminated and the layer may then be removed with the substrate 43 following cooling. When paraffin has been added to the liquid dispersion as mentioned above, the layer may be heated along with the substrate to about 300°C in an electric oven to remove paraffin by vaporization or cracking. If necessary, a platinum plate or other heat-resistant plate may be used as a substrate and baked at a higher temperature to form a baked substrate plate.

In the present method, orientation of the pyroelectric axes is thought to occur by the following mechanism. When the colloidal solution has been sprayed, numerous $LiNbO_3$ crystalline particles are contained in each droplet of the colloidal solution. Since these particles are cooled rapidly by absorption of the latent heat of vaporization of the trichloroethylene, electric dipoles corresponding to respective pyroelectric axes will appear in respective crystalline particles contained in the droplets, these axes being oriented in the same direction and polarity under the impressed electrical field. Upon vaporization of liquid trichloroethylene, the sprayed particles are turned into secondary particles consisting of the $LiNbO_3$ particles that are oriented in the above manner and deposited in a layer on the substrate electrode.

The spray nozzle used for spraying the colloidal solution may be replaced by an ultrasonic spraying apparatus (so-called humidifier). The ultrasonic spraying apparatus allows a stable spraying operation for a prolonged time and yields uniformly polarized $LiNbO_3$ particles.

The particles may undergo temperature increase instead of temperature decrease through absorption of the heat of vaporization. For example, the particles may be heated by the aforementioned heating table to overcome the effect of cooling which is obtained through absorption of the heat vaporization. Alternatively, the crystal particles sprayed towards the electrode surface may be heated directly by radiation of microwaves or light heating wavelengths specific to the particles. In this case, the crystalline particles may be tinted or otherwise processed superficially for indicating their specific absorption wavelengths. In this manner, the particles thus sprayed and approaching the electrode surface undergo uniform changes in temperature so that electric dipoles will appear due to the pyroelectric effects, and the particles will be deposited on the electrode surface while being polarized by the electric field. The layer of the deposited particles may then be dried to form a layer of polarized pyroelectric crystalline particles, that is, a polycrystal pyroelectric material, which may be baked if desired. Complex pyroelectric bodies may also be obtained easily.

In the methods described above, electrical deposition or spraying is used for yielding a polycrystalline pyroelectric material consisting only of pyroelectric crystalline particles. However, in an unbaked state, the bonding force acting between the crystalline particles and between the particles and the substrate is rather low. In addition, when the pyroelectric crystalline particles are oxides, the baking temperature is higher, so that the substrate electrode material is required to be highly heat-resistant and hence inexpensive material such as glass plate cannot be used as electrode material. With this in view, methods of manufacturing a complex pyroelectric body, containing binder materials in addition to the pyroelectric crystalline particles, will now be described.

In method of manufacturing such complex pyroelectric material, vitreous materials or solid paraffin may, for example, be used as the binder. These materials may be dispersed in advance into a liquid dispersion such as trichloroethylene, or impregnated into the layer of pyroelectric crystalline particles once formed on the electrode and subsequently taken out and dried.

The fifth and sixth methods described below are directed to the former method for manufacture of the complex pyroelectric material, while the seventh and eighth methods are directed to the latter method for manufacture of such material.

In the fifth method, to manufacture a pyroelectric material consisting of $LiNbO_3$ crystalline particles by an electric deposition method as in the first to third methods described above, about 0.1 wt. percent of solid paraffin is dissolved in advance into a trichloroethylene dispersion medium. The resulting layer of the deposited particles may be taken out of the liquid along with the electrode and dried to form a complex pyroelectric material having a uniform reinforced binding force between the particles and between the particles and the electrode plate. This allows the binder to be impregnated uniformly and without inclusion of air bubbles, as compared to the case wherein paraffin is impregnated into the completed polycrystalline pyroelectric material.

The sixth method is directed to the manufacture of a complex pyroelectric material consisting of pyroelectric crystalline particles and vitreous materials as binder. The vitreous material, such as powdered solder glass with a lower melting point, is used as a binder. The material is comminuted in a mortar in the same manner as the $LiNbO_3$ particles described above, and precipitated in ethanol to form a powder less than about 1 μm in diameter.

The resulting particles are oleophilized by surface processing and recovered by a centrifugal separator. The powder is thoroughly washed with toluene and dried with a hot air drier. About 10 wt. percent of the resulting solder glass powder with oleophilized surfaces and less than 1 μm in diameter are mixed with the $LiNbO_3$ powders, and the resulting mixture is dispersed thoroughly in trichloroethylene to form a colloidal solution by application of ultrasonic waves. A pair of opposing electrodes are placed in the solution to effect deposition of the particles on the electrode surface by electrophoresis by application of a substantially uniform change of temperature. The particles deposited in this manner on the electrode plate and oriented in their pyroelectric axes are then taken out of the solution and heated to about 500°C in an electric oven. The $LiNbO_3$ particles are thus fused to the electrode substrate with the air of the solder glass as binder.

To adapt this method for use with a spray method, 1.0 g of the surface processed $LiNbO_3$

particles and 0.1 g of the glass powder are dispersed into 50 cc of trichloroethylene, to which 0.1 g of solid paraffin is dissolved in advance, by application of ultrasonic waves, and the resulting colloidal solution is then sprayed into the space between the opposing electrodes for depositing the pyroelectric crystalline particles on the substrate electrode under application of a substantially uniform temperature change or gradient. The particles thus deposited on the electrode plate with oriented pyroelectric axes may then be heated to about 480°C by using an electric oven for fusing the $LiNbO_3$ particles to the electrode substrate by a solder glass as binder.

The complex pyroelectric material of the sixth method obtained by heating as described above is superior in heat resistancy and need not be treated at an elevated temperature in the baking process, so that the nesa glass substrate used as the electrode may be used in situ as the substrate for the pyroelectric material. Moreover, it is possible to obtain a complex pyroelectric material in which there is no inclusion of air bubbles and the binding force between the particles and between the substrate and the binder can be reinforced uniformly. A material that is turned into glass upon heat treatment may be used as binder.

The fifth and sixth methods for the manufacture of a complex pyroelectric material mentioned above include the step of depositing pyroelectric crystalline particles on the substrate with oriented pyroelectric axes to form a layer of a polycrystalline pyroelectric material, and then impregnating the layer with a binder.

Thermoplastic organic materials or organic materials hardened upon copolymerization such as paraffin, vinyl chloride-vinyl acetate copolymers, polyurethane, epoxy resin or polyester resin in solution, can be used either singly or in combination as the binder. A mixed system that is ultimately converted into a binder through cracking or combination by heating, as for instance an aqueous solution of borate anhydride and lead acetate that is ultimately converted into lead borate type glass, may also be used as a binder.

Referring now to the seventh method according to the present invention, a layer of pyroelectric crystalline particles is formed on the electrode by electro-deposition or spraying and is dried to form a polarized polycrystalline pyroelectric material in the manner described in the first to fifth methods. Since the surface of the crystalline particles of the pyroelectric material is oleophilized by the aforementioned surface treatment, when the dissolved paraffin, transparent lacquer paint diluted with a thinner or the like oily solvent is impregnated into these particles, the solvent permeates into the particle interstices and is turned into a binder which binds the crystalline particles to one another and the crystalline particles to the substrate. Moreover, when the layer formed of pyroelectric crystalline particles is heated to about 500°C, silane coupling agents are cracked and vaporized from the surface of the $LiNbO_3$ crystalline particles, hydrophilizing the particle surface. An aqueous solution of polyvinyl alcohol (PVA) may then be permeated into the polycrystalline pyroelectric body which may then be dried to a complex pyroelectric material.

In the eighth method according to the present invention, a mixed system solution which is ultimately converted into a vitreous material by heating, is used as binder.

In this eighth method, a polycrystalline pyroelectric material consisting of a layer of polarized and deposited pyroelectric crystal particles is produced by a process similar to that of the first to fourth methods. A mixed aqueous solution consisting of the following ingredients may be used as a mixed liquid system that is converted into vitreous material upon heating.

| | |
|---|---|
| $(B_2O_3)$ | 3.48 g |
| lead acetate $(Pb(CH_3CO_2)_2 \cdot 3H_2O$ | 18.96 g |
| water $(H_2O)$ | 100 g |
| acetic acid $(CH_3COOH)$ | trace (less than 1 g) |

Since the polycrystalline pyroelectric material is oleophilized at the crystalline particle surface zone thereof, it is first processed by heating to about 450°C for cracking or vaporizing the silane coupling agent and hydrophilizing the crystalline particle surface, and is then impregnated thoroughly with the mixed aqueous solution. After spontaneous drying, the resulting pyroelectric material is heated to about 480°C for 30 minutes in an electric oven. In this manner, the layer of $LiNbO_3$ crystalline particles is vitreously fused resulting in formation of a complex pyroelectric material with a strong binding force. Such increase in the binding force caused by vitreous fusion is not accompanied by any appreciable decrease in pyroelectric properties.

With the eighth method, vitreous material can be impregnated uniformly without inclusion of air bubbles as compared to the case of impregnating a colloidal solution with dispersed glass particles, wherein glass particles tend to block the particle interstices and prevent permeation. Moreover, there may be obtained a complex pyroelectric material with superior pyroelectric properties and improved packing density of pyroelectric crystalline particles.

In the eighth method, mixed solutions that may be turned into glass, such as zinc borate, barium borate, alkaline aluminium phosphate or alkaline lead silicate may be used as binder in addition to the mixed solution for providing a vitreous composition of the lead borate system. It has also been found that the addition of a trace amount of ethanol or soap to the aqueous solution is helpful to permeat the solution into the layer of the crystalline particles.

**Claims**

1. A method of preparing a pyroelectric material, the method comprising:

dispersing crystalline pyroelectric particles in a liquid;

introducing the resulting dispersion between an opposing pair of electrodes; and

establishing an electric field between said electrodes with a sufficient magnitude to cause said particles to be deposited in a layer on one of said electrodes;

characterised by:

changing the temperature of said particles before deposition of said particles on said one electrode, the temperature change being sufficient to orient the pyroelectric axes of the crystalline particles in the deposited layer.

2. A method according to claim 1 wherein said electrodes are immersed in said dispersion.

3. A method according to claim 1 wherein said dispersion is sprayed into the space between said electrodes.

4. A method according to claim 1, claim 2 or claim 3 wherein said temperature of said particles is changed between the time they enter said electric field and the time they are deposited in said layer.

5. A method according to any one of the preceding claims of preparing a complex pyroelectric material, wherein a binder material is dispersed in said liquid, in addition to said crystalline pyroelectric particles, so that said deposited layer comprises a pyroelectric structure co-deposited with said binder material.

6. A method according to claim 5 wherein said binder material is paraffin dispersed in an organic solvent.

7. A method according to claim 1 which includes the further steps of premixing said crystalline pyroelectric particles with particles of a vitreous binder, and heating said layer to a temperature sufficient to fuse said binder.

8. A method according to claim 1 which includes the steps of dispersing said crystalline pyroelectric particles and particles of a vitreous binder in said liquid having paraffin dissolved therein, spraying the resulting colloidal dispersion into the space between said electrodes, and thereafter heating said layer to a temperature sufficient to fuse said vitreous binder to the electrode surface.

**Patentansprüche**

1. Verfahren zum Präparieren eines pyroelektrischen Materials, welches Verfahren aufweist:

Dispergieren kristalliner pyroelektrischer Partikel in einer Flüssigkeit,.

Einführen der sich ergebenden Dispersion zwischen ein Paar von sich gegenüberliegenden Elektroden und

Aufbauen eines elektrischen Feldes zwischen den Elektroden mit einer ausreichenden Stärke, um zu veranlassen, daß die Partikel sich in einer Schicht auf einer der Elektroden niederschlagen, gekennzeichnet durch

Ändern der Temperatur der Partikel vor deren Niederschlagung auf der einen Elektrode, wobei due Temperaturänderung ausreichend ist, um die pyroelektrischen Achsen der kristallinen Partikel in der niedergeschlagenen Schicht zu orientieren.

2. Verfahren nach Anspruch 1, bei dem die Elektroden in die Dispersion eingetaucht werden.

3. Verfahren nach Anspruch 1, bei dem die Dispersion in den Raum zwischen den Elektroden gesprüht wird.

4. Verfahren nach Anspruch 1, 2 oder 3, bei dem die Temperatur der Partikel zwischen dem Zeitpunkt, zu dem sie in das elektrische Feld eintreten, und dem Zeitpunkt, zu dem sie in der Schicht niedergeschlagen werden, geändert wird.

5. Verfahren nach einem der vorhergehenden Ansprüche zum Präparieren eines komplexen pyroelektrischen Materials, bie dem ein Bindemittel zusätzlich zu den kristallinen pyroelektrischen Partikeln in der Flüssigkeit dispergiert wird, so daß die niedergeschlagene Schicht eine pyroelektrische Struktur aufweist, die zusammen mit dem Bindemittel niedergeschlagen ist.

6. Verfahren nach Anspruch 5, bei dem das Bindemittel Paraffin ist, das in einem organischen Lösungsmittel dispergiert ist.

7. Verfahren nach Anspruch 1, das weitere Schritte zum Vormischen der kristallinen pyroelektrischen Partikel mit Partikeln eines glasähnlichen Bindemittels und Erhitzen der Schicht auf eine Temperatur, die ausreichend ist, um das Bindemittel zu schmelzen, enthält.

8. Verfahren nach Anspruch 1, das Schritte zur Dispergierung der kristallinen pyroelektrischen Partikel und von Partikeln eines glasähnlichen Bindemittels in der Flüssigkeit, die in sich gelöstes Paraffin enthält, zum Sprühen der sich ergebenden kolloidalen Dispersion in den Raum zwischen den Elektroden und danach zum Erhitzen der Schicht auf eine Tempertur, die ausreichend ist, um das glasähnliche Bindemittel auf die Elektrodenoberfläche aufzuschmelzen, enthält.

**Revendications**

1. Procédé pour préparer une matière pyroélectrique, procédé comprenant:

la dispersion des particules pyroélectriques cristallines dans un liquide;

l'introduction de la dispersion résultante entre deux électrodes placées face à face; et

l'établissement entre lesdites électrodes d'un champ électrique d'une amplitude suffisante pour provoquer le dépôt desdites particules en une couche sur l'une des électrodes,

procédé caractérisé

en ce qu'on fait varier la température desdites particules avant leur dépôt sur ladite électrode, la variation de température étant suffisante pour orienter les axes pyroélectriques des particules cristallines dans la couche obtenue par le dépôt.

2. Procédé selon la revendication 1, dans lequel lesdites électrodes sont immergées dans ladite dispersion.

3. Procédé selon la revendication 1, dans lequel ladite dispersion est projetée par pulvérisation dans l'espace situé entre lesdites électrodes.

4. Procédé selon la revendication 1, la revendication 2 ou la revendication 3, dans lequel on fait varier la température desdites particules entre le moment où les particules pénètrent dans ledit champ électrique et le moment de leur dépôt dans ladite couche.

5. Procédé selon l'une quelconque des revendications précédentes pour préparer une matière pyroélectrique complexe, dans lequel on disperse une matière liante dans ledit liquide, en plus desdites particules pyroélectriques cristallines, de sorte que la couche obtenue par dépôt comprend une structure pyroélectrique co-déposée avec ladite matière liante.

6. Procédé selon la revendication 5, dans lequel ladite matière liante est de la paraffine dispersée dans un solvant organique.

7. Procédé selon la revendication 1, qui comprend les étapes supplémentaires consistant à mélanger au préalable lesdites particules pyroélectriques cristallines avec des particules d'un liant vitreux, et à chauffer ladite couche jusqu'à une température suffisante pour provoquer la fusion de ce liant.

8. Procédé selon la revendication 1, qui comprend les étapes consistant à disperser lesdites particules pyroélectriques cristallines et les particules d'un liant vitreux dans ledit liquide dans lequel de la paraffine est dissoute, à projeter par pulvérisation la dispersion colloïdale résultante dans l'espace situé entre lesdites électrodes, puis à chauffer ladite couche jusqu'à une température suffisante pour provoquer la fusion dudit liant vitreux à la surface de l'électrode.

0 083 667

# FIG.1

## A

Ps

Peff

## B

Ps

# FIG.2

# FIG.3

# FIG.4

# *FIG.5*

# *FIG.6*

# FIG.7

# FIG.8